# EUROPÄISCHE PATENTSCHRIFT

(11) **EP 3 352 235 B1**
(45) Veröffentlichungstag und Bekanntmachung des Hinweises auf die Patenterteilung: **01.05.2019**
(21) Anmeldenummer: 18151152.8
(22) Anmeldetag: 11.01.2018
(51) Int. Cl.: H01L 39/24

(54) **VERFAHREN ZUR FERTIGUNG EINES HALBZEUGS FÜR EINEN SUPRALEITERDRAHT**
METHOD FOR PRODUCING A SEMI-FINISHED PRODUCT FOR A SUPERCONDUCTING WIRE
PROCÉDÉ DE FABRICATION D'UN DEMI-PRODUIT POUR UN FIL SUPRACONDUCTEUR

(30) Priorität: 23.01.2017 DE 102017201039
(43) Veröffentlichungstag der Anmeldung: 25.07.2018
(73) Patentinhaber: Bruker EAS GmbH, 63450 Hanau (DE)
(72) Erfinder: Abächerli, Vital, 63526 Erlensee (DE); Schlenga, Klaus, 76149 Karlsruhe (DE); Sailer, Bernd, 63755 Alzenau (DE); Thöner, Manfred, 63599 Biebergemünd (DE); Wanior, Matheus, 63571 Gelnhausen (DE)
(74) Vertreter: Kohler Schmid Möbus Patentanwälte

(56) Entgegenhaltungen:
- WO-A1-93/02222
- DE-A1- 1 483 365
- US-B1- 9 023 765
- C A Terrazas ET AL: "EBM FABRICATION AND CHARACTERIZATION OF HIGH PURITY NIOBIUM FOR SUPERCONDUCTOR APPLICATIONS", 25th annual international solid freeform fabrication symposium. An additive manufacturing conference, 1. Januar 2014 (2014-01-01), Seiten 605-616, XP055482063, Gefunden im Internet: URL:https://sffsymposium.engr.utexas.edu/s ites/default/files/2014-050-Terrazas.pdf [gefunden am 2018-06-07]

## Beschreibung

Die Erfindung betrifft ein Verfahren zur Fertigung eines Halbzeugs für einen Supraleiterdraht,
wobei das Halbzeug wenigstens eine NbTi-haltige Struktur, insbesondere NbTi-haltige Stabstruktur, umfasst.

Ein solches Verfahren ist beispielsweise aus der US 5,223,348 bekannt geworden.

NbTi-Supraleiterdrähte werden dazu eingesetzt, große elektrische Ströme praktisch verlustfrei zu führen, insbesondere in supraleitenden Magnetspulen zur Erzeugung starker Magnetfelder. NbTi hat dabei den Vorteil einer guten Duktilität, was die Verarbeitung des Materials erleichtert; insbesondere sind plastische Umformungen gut möglich.

Die Stromtragfähigkeit eines NbTi-Supraleiterdrahts kann durch künstliche Haftzentren (artificial pinning centers) im supraleitenden Material, die die magnetischen Flussschläuche festhalten, verbessert werden.

Eine häufig genutzte Methode, um Haftzentren in NbTi-Material einzubringen, verwendet eine Abfolge von Wärmebehandlungen und Zugverformungen ("Stangen- und Drahtzug"). Dadurch kommt es an NbTi-Korngrenzen zu Ausscheidungen von α-Ti, die als Haftzentren wirken. Weiterhin ist es bekannt, in einer NbTi-Matrix Filamente eines Übergangsmetalls (etwa Niob, Titan oder Vanadium) einzubringen, die als künstliche Haftzentren wirken. Auch ist es bekannt geworden, Niob und Titan in wechselnden Schichten zu einem Rohling zusammenzufügen, zu ziehen, und zu einem zweiten Rohling zu bündeln. Der zweite Rohling wird heißisostatisch gepresst ("HIP" Prozess), extrudiert und zu einem Draht umgeformt. An den Grenzflächen von Ti und Nb entsteht NbTi, wobei jedoch aufgrund unvollständiger Reaktion etwas normalleitendes Material übrigbleibt. Weiterhin ist es bekannt, Stapel von wechselnden Nb-Schichten und Ti-Schichten mit Nb zu umhüllen und in eine Extrusionshülle aus Kupfer einzuführen. Nach einem HIP-Prozess, einer Extrusion und einem Ziehen wird die Extrusionshülle entfernt und die erhaltenen Filamente werden gestapelt. Anschließend erfolgt wiederum ein Einbringen in eine Cu-Extrusionshülle, ein HIP-Prozess, eine Extrusion, ein Ziehen, ein Entfernen der Extrusionshülle, ein Stapeln und Umhüllen mit Nb. Durch erneutes Einbringen in eine Extrusionshülle aus Cu, einen HIP-Prozess, Extrudieren und Ziehen wird schließlich ein fertiger NbTi-haltiger Draht erhalten. Diese Verfahren sind beispielsweise in der US 5,223,348 zusammengefasst.

Die Einbringung Haftzentren in NbTi-Supraleitermaterial mit den bekannten Methoden ist aufwändig und schwierig. Für das Ausscheiden von α-Titan ist eine sehr genaue Verfahrensführung nötig. Für das Einbringen von anderen Materialien in eine NbTi-Matrix sind aufwändige mechanische Kombinationsschritte nötig; entsprechendes gilt für die Kombination von abwechselnden Schichten aus Nb und Ti.

Zur Herstellung von metallischen Bauteilen anhand von CAD-Daten ist es bekannt geworden, das Bauteil in Schichten durch lokales Aufschmelzen eines Metallpulvers mit einem Laserstrahl oder Elektronenstrahl zu fertigen ("Selektives Laserschmelzen" bzw. "Selektives Elektronenstrahlschmelzen"), vgl. beispielsweise die Internetseite http://netzkonstrukteur.de/fertigungstechnik/3d-druck/selektiveslaserschmelzen/
aufgerufen am 6.7.2016, oder auch die Internetseite http://netzkonstrukteur.de/fertigungstechnik/3d-druck/selektiveselektronenstrahlschmelzen/
aufgerufen am 22.11.2016. Die Fertigungsmethode benötigt keine Negativ-Formen und ermöglicht Hinterschnitte.

Die Herstellung von supraleitenden Formteilen (Nb RF Resonatoren) mittels selektiven Elektronenstrahlschmelzens ist zum Beispiel aus der US 9 023 765 B1 bekannt.

### Aufgabe der Erfindung

Der Erfindung liegt die Aufgabe zugrunde, die Einbringung von künstlichen Haftzentren (artificial pinning centers) in das NbTi-Material eines Supraleiterdrahts bzw. eines Halbzeugs für einen solchen Supraleiterdraht zu vereinfachen.

### Kurze Beschreibung der Erfindung

Diese Aufgabe wird gelöst durch ein Verfahren der eingangs genannt Art, das dadurch gekennzeichnet ist, dass die NbTi-haltige Struktur schichtweise durch selektives Laserschmelzen oder selektives Elektronenstrahlschmelzen eines Pulvers, das Nb und Ti enthält, gefertigt wird,
und dass bei der Fertigung zumindest einiger Schichten der NbTi-haltigen Struktur über die Fertigung eines für eine Materialabscheidung vorgesehenen, bestrahlten Bereichs einer jeweiligen Schicht ein oder mehrere Prozessparameter des selektiven Laserschmelzens oder Elektronenstrahlschmelzens in einer oder mehreren ersten Zonen des bestrahlten Bereichs gegenüber einer oder mehreren zweiten Zonen des bestrahlten Bereichs variiert werden.

Im Rahmen der Erfindung wird eine NbTi-haltige Struktur, die in einem Halbzeug für einen NbTi-Supraleiterdraht verwendet wird oder unmittelbar als Halbzeug für einen NbTi-Supraleiterdraht verwendet wird, durch schichtweises selektives Laserschmelzen oder Elektronenstrahlschmelzen eines Pulvers (pulverförmigen Materials) gefertigt. Das schichtweise Herstellen einer Struktur durch selektives Laserschmelzen bzw. Elektronenstrahlschmelzen ist auch im Rahmen der additiven Fertigung (additive manufacturing) bekannt geworden.

In jeder Schicht wird dabei jeweils ein Bereich vorgesehen, der vom Laserstrahl oder Elektronenstrahl überstrichen wird und dadurch lokal aufgeschmolzen wird, sodass dort die Pulverkörner miteinander verbunden werden ("laserbestrahlter Bereich" bzw. "elektronenstrahlbestrahlter Bereich", auch kurz bezeichnet als "bestrahlter Bereich"). Der laserbestrahlte bzw. elektronenstrahlbestrahlte Bereich kann dabei auch mehrere unverbundene Teilbereiche umfassen. Zudem wird in der Regel auch ein anderer Bereich einer jeweiligen Schicht nicht vom Laserstrahl bzw. Elektronenstrahl überstrichen, so dass dort die Pulverkörner unverbunden verbleiben ("unbestrahlter Bereich"). Der unbestrahlte Bereich kann dabei ebenfalls mehrere unverbundene Teilbereiche umfassen. In der Regel wird eine Vielzahl von Schichten nacheinander und aufeinander gefertigt, meist 100 Schichten oder mehr, wobei in jeder Schicht der jeweilige dortige, laserbestrahlte bzw. elektronenstrahlbestrahlte Bereich verfestigt wird. Das verbleibende Pulver nach Fertigung aller Schichten wird entfernt, und die NbTi-haltige Struktur wird erhalten.

Die Erfindung sieht nun vor, in dem jeweiligen laserbestrahlten bzw. elektronenstrahlbestrahlten Bereich zumindest einiger (ggf. auch aller) Schichten bei der Fertigung der NbTi-haltigen Struktur keine homogene Laserschmelzbearbeitung bzw. Elektronenstrahlschmelzbearbeitung vorzunehmen, sondern den laserbestrahlten bzw. elektronenstrahlbestrahlten Bereich in eine oder mehrere erste Zonen und eine oder mehrere zweite Zonen zu unterteilen. In der oder den ersten Zonen wird das Laserschmelzen bzw. Elektronenstrahlschmelzen mit anderen Prozessparametern durchgeführt als in der oder den zweiten Zonen. Dadurch unterscheidet sich das erhaltene, verfestigte Material in der oder den ersten Zonen ("erstes Material") von dem erhaltenen, verfestigten Material in der oder den zweiten Zonen ("zweites Material").

Die verschiedenen Zonen mit unterschiedlichen erhalten Materialien führen dazu, dass magnetische Flussschläuche in ihrer Bewegung behindert werden. Die Grenzfläche oder Grenzflächen zwischen den Zonen, oder auch die Zone oder Zonen eines Typs (etwa die zweiten Zonen), oder auch Bestandteile der Zone oder der Zonen eines Typs (etwa der zweiten Zonen) wirken als künstliche Haftzentren.

Typischerweise wird das Verfahren so geführt, dass eines der erhaltenen Materialien (etwa das erste Material) supraleitend ist, etwa mit einer Nb_{53gew%}Ti_{47gew%}-Phase, und das andere der Materialien (etwa das zweite Material) nicht supraleitend ist oder jedenfalls einen erhöhten Anteil von nicht supraleitender Phase oder Phasen aufweist, etwa mit einer reinen Nb-Phase oder z.B. einer Nb_{60gew%}Ti_{40gew%}-Phase (=Nb_{44at%}Ti_{56at%}-Phase).

Durch die unterschiedlichen Prozessparameter beim Laserschmelzen bzw. Elektronenstahlschmelzen für die erste Zone(n) und die zweite(n) Zone(n) kann auf die chemische Zusammensetzung, die Phasenverteilung und/oder das Gefüge von erstem und zweitem Material Einfluss genommen werden. Insbesondere können Verdampfungs-, Schmelz-, Diffusions-, Erstarrungs-, Ausscheidungs- und Kristallisationsprozesse über die Parameter des selektiven Laserschmelzens bzw. Elektronenstahlschmelzens beeinflusst werden.

Die Veränderung der Parameter des Laserschmelzens bzw. Elektronenstahlschmelzens ist vergleichsweise einfach, und im Rahmen der schichtweisen Fertigung ist problemlos ein Zugang zum Inneren der zu fertigenden NbTi-haltigen Struktur möglich. Dadurch können künstliche Haftzentren praktisch beliebig in der zu fertigenden NbTi-haltigen Struktur platziert werden. Insbesondere kann auch leicht eine große Anzahl von künstlichen Haftzentren mit relativ kleinem Volumenanteil an der Gesamtstruktur eingebracht werden, was die supraleitende Stromtragfähigkeit verbessert. Bevorzugt besteht die NbTi-haltige Struktur zu wenigstens 80 gew%, besonders bevorzugt wenigstens 95 gew%, besonders bevorzugt wenigstens 99 gew% aus einer supraleitenden NbTi-Phase.

Eine NbTi-haltige Struktur hat typischerweise eine Länge L zwischen 30 cm und 1,50 m, bevorzugt zwischen 50 cm und 1 m, und hat weiterhin typischerweise einen Durchmesser D zwischen 5 cm und 50 cm, bevorzugt zwischen 10 cm und 25 cm (Ingot-Anwendungen), oder auch einen Durchmesser zwischen 5 mm und 100 mm (Anwendung für direkten Einsatz in Matrix). Die NbTi-haltige Struktur weist typischerweise entlang einer axialen Richtung einen konstanten Außenquerschnitt auf ("Stabstruktur").

### Bevorzugte Ausführungsformen und Varianten der Erfindung

Bei einer bevorzugten Variante des erfindungsgemäßen Verfahrens wird beim selektiven Laserschmelzen oder Elektronenstahlschmelzen in der oder den zweiten Zonen der Gehalt an Ti gegenüber der oder den ersten Zonen abgereichert. Dadurch kann leicht aus einer Pulverzusammensetzung mit einem üblichen Zusammensetzungsverhältnis passend für die supraleitende Nb_{53gew%}Ti_{47gew%}-Phase eine (bei üblichen Einsatztemperaturen um 4,2 K) nicht supraleitfähige Nb_{60gew%}Ti_{40gew%}-Phase (=Nb_{44at%}Ti_{56at%}-Phase) erzeugt werden, die für die Ausbildung von künstlichen Haftzentren gut geeignet ist. Für die Abreicherung des Ti kann der deutlich niedrigere Siedepunkt von Ti gegenüber Nb genutzt werden. Bei kurzen Einwirkzeiten bzw. niedriger Strahlleistung beim Einwirken des Laserstrahls bzw. Elektronenstrahls auf ein lokales pulverförmiges Material bzw. lokales Schmelzbad kommt es zu keiner oder nur geringfügigere Abreicherung von Ti, und durch längere Einwirkzeiten bzw. höhere Strahlleistung kann die Abreicherung von Ti forciert werden.

Eine ebenfalls vorteilhafte Variante sieht vor, dass beim selektiven Laserschmelzen oder Elektronenstahlschmelzen in der oder den zweiten Zonen eine maximale Temperatur eines Schmelzbades gegenüber der oder den ersten Zonen erhöht ist. Dadurch kann ein Abreichern von Ti, das einen niedrigeren Siedepunkt (3287 °C) hat als Nb (4927 °C), befördert werden. Typischerweise liegt die maximale Schmelzbadtemperatur in einer zweiten Zone im Bereich des Siedepunkts von Ti (bevorzugt ca. 3200-3300 °C), und in einer ersten Zone deutlich darunter (bevorzugt ca. 1800-3000 °C). Die maximale Schmelzbadtemperatur in der ersten Zone liegt dabei aber oberhalb der Schmelzpunkte von Ti (1668 °C) und von Nb (2469 °C).

Bevorzugt ist auch eine Variante, bei der beim selektiven Laserschmelzen oder Elektronenstahlschmelzen in der oder den zweiten Zonen eine lokale Verweildauer eines Schmelzbades gegenüber der oder den ersten Zonen erhöht ist. Dadurch ist eine Zeit für Abdampfprozesse aus dem Schmelzbad in einer zweiten Zone verlängert, wodurch die chemische Zusammensetzung verändert werden kann, etwa zum Abreichern von Ti. Die Verweildauer kann leicht über die Steuerung des Laserstrahls bzw. Elektronenstrahls bzw. dessen Aufpunkts, etwa ein motorisch verfahrbares und/oder verschwenkbares Spiegelsystem oder ein elektrisch ansteuerbares Linsensystem, beeinflusst werden.

Bei einer vorteilhaften Variante ist beim selektiven Laserschmelzen oder Elektronenstrahlschmelzen in der oder den zweiten Zonen eine Strahlleistung gegenüber der oder den ersten Zonen erhöht. Über die Strahlleistung (Laserleistung bzw. Elektronenstrahlleistung) kann der Energieeintrag in das bestrahlte Pulver verändert werden, etwa um die Temperatur im Schmelzbad zu beeinflussen. Falls gewünscht, kann in dieser Variante die Strahlführung des Laserstrahls bzw. Elektronenstrahls über den bestrahlten Bereich gleichmäßig erfolgen.

Weiterhin bevorzugt ist eine Verfahrensvariante, wobei beim selektiven Laserschmelzen oder Elektronenstrahlschmelzen in der oder den zweiten Zonen eine Vorschubgeschwindigkeit eines Aufpunkts eines Laserstrahls oder Elektronenstrahls gegenüber einer Vorschubgeschwindigkeit des Aufpunkts in der oder den ersten Zonen verringert ist. Durch Verringerung der Vorschubgeschwindigkeit kann der Energieeintrag pro überstrichene Fläche erhöht werden, etwa um die Temperatur des Schmelzbades zu erhöhen. Die Vorschubgeschwindigkeit kann leicht über die Steuerung des Laserstrahls oder Elektronenstrahls bzw. dessen Aufpunkts, etwa mittels eines motorisch verfahrbaren und/oder verschwenkbaren Spiegelsystems oder eines elektrisch ansteuerbaren Linsensystems, beeinflusst werden.

Ebenfalls vorteilhaft ist eine Verfahrensvariante, bei der beim selektiven Laserschmelzen oder Elektronenstrahlschmelzen in der oder den zweiten Zonen die Fokussierung des Laserstrahls oder Elektronenstrahls gegenüber der oder den ersten Zonen verändert ist. Dadurch kann der Energieeintrag pro Fläche beeinflusst werden. Typischerweise ist der Laserstrahl bzw. Elektronenstrahl in der oder den zweiten Zonen gegenüber der oder den ersten Zonen verengt.

Vorteilhaft ist zudem eine Verfahrensvariante, die vorsieht, dass beim selektiven Laserschmelzen oder Elektronenstrahlschmelzen in der oder den ersten Zonen eine erste Laserquelle oder Elektronenkanone eingesetzt wird, und beim selektiven Laserschmelzen oder Elektronenstrahlschmelzen in der oder den zweiten Zonen eine zweite Laserquelle oder Elektronenkanone alternativ oder zusätzlich zur ersten Laserquelle oder Elektronenkanone eingesetzt wird. Dadurch kann die lokal einwirkende Strahlleistung verändert werden, ohne die Leistung eines einzelnen Lasers bzw. einer einzelnen Elektronenkanone durchstimmen zu müssen.

Bevorzugt ist auch eine Variante, bei der die NbTi-haltige Struktur mit einer Länge L in Längsrichtung und einen maximalen Durchmesser D senkrecht zur Längsrichtung gefertigt wird, mit L≥3*D, bevorzugt L≥4*D, besonders bevorzugt L≥5*D. Das erfindungsgemäß eingesetzte selektive Laserschmelzen bzw. Elektronenstrahlschmelzen ist gut dazu geeignet, auch größere Aspektverhältnisse von L/D zu fertigen. Weiterhin ist es auch gut möglich, große Aspektverhältnisse der (linearen) maximalen Ausdehnung MA einer (meist zweiten) Zone quer zur Längsrichtung im Verhältnis zur Länge L in Längsrichtung einzurichten. Meist gilt L ≥ 10*MA oder sogar L ≥ 30*MA. Entsprechende Aspektverhältnisse sind auf mechanischem Wege (etwa durch Bohren und Einsetzen von Füllstäben) nur sehr aufwändig und schwierig zu fertigen.

Besonders bevorzugt ist eine Weiterbildung dieser Verfahrensvariante, bei der die NbTi-haltige Struktur schichtweise senkrecht zu ihrer Längsrichtung gefertigt wird. Dadurch sind etwaige flächenhafte Fehler oder nicht supraleitende Flächen, die zwischen zwei Schichten eingebracht werden, parallel zur Längsrichtung und damit parallel zur Stromflussrichtung orientiert und haben daher nur einen geringen Einfluss auf die Stromtragfähigkeit. Entsprechend sind bei diesem Vorgehen besonders hohe Stromtragfähigkeiten des fertigen NbTi-Supraleiterdrahts möglich. Man beachte, dass für diese Weiterbildung das pulverförmiges Material und der Laserstrahl bzw. Elektronenstrahl über eine vergleichsweise große Strecke bzw. große Fertigungsfläche verteilt bzw. geführt werden muss; jedoch ist nur eine geringe Hubhöhe erforderlich.

Bei einer alternativen Weiterbildung der obigen Verfahrensvariante wird die NbTi-haltige Struktur schichtweise entlang ihrer Längsrichtung gefertigt. In diesem Fall kann eine vergleichsweise kleine Bauplattform eingesetzt werden.

Bevorzugt ist auch eine Verfahrensvariante, bei der die eine oder die mehreren zweiten Zonen im bestrahlten Bereich jeweils eine maximale Ausdehnung zwischen 5 µm und 1000 µm haben. Die maximale (lineare) Ausdehnung MA wird senkrecht zur Längsrichtung / Stromtragrichtung gemessen. Meist liegen die maximalen Ausdehnungen MA bei 20 µm oder mehr, oft auch bei 40 µm oder mehr. Weiterhin liegen die maximalen Ausdehnungen MA meist bei 500 µm oder weniger, oft bei 250 µm oder weniger. Solche maximalen Ausdehnungen MA sind mit dem erfindungsgemäßen Verfahren relativ einfach zu fertigen, im Gegensatz zu mechanischen Verfahren.

Bei einer vorteilhaften Variante ist vorgesehen, dass in aufeinanderfolgenden Schichten zweite Zonen nicht überlappen,
bevorzugt wobei über wenigstens fünf aufeinanderfolgende Schichten zweite Zonen nicht überlappen. Dadurch werden in Fertigungsrichtung größere zusammenhängende, nicht supraleitende Bereiche in der NbTi-haltigen Struktur vermieden. Diese Variante wird vor allem eingesetzt, wenn die Fertigungsrichtung (Richtung, in der die Schichten aufeinanderfolgen) senkrecht zur Längsrichtung ist.

Bei einer anderen Variante ist vorgesehen, dass zweite Zonen aufeinanderfolgender Schichten zumindest teilweise überlappen, so dass sich in der NbTi-haltigen Struktur eine zusammenhängende Raumstruktur von zweiten Zonen ausbildet. Durch diese Variante ist es möglich, Bereiche für Flussschläuche sehr gezielt einzurichten und insbesondere an eine Orientierung eines äußeren Magnetfelds gezielt anzupassen. Dadurch kann ebenfalls die Stromtragfähigkeit erhöht werden. Diese Variante wird vor allem eingesetzt, wenn die Fertigungsrichtung (Richtung, in der die Schichten aufeinanderfolgen) entlang der Längsrichtung ist.

Bei einer bevorzugten Verfahrensvariante wird die NbTi-haltige Struktur einer querschnittsreduzierenden Umformung ausgesetzt. Bei der querschnittsreduzierenden Umformung kann auch eine Verdichtung erfolgen. Eine querschnittsreduzierende Umformung erfolgt insbesondere nach schichtweiser Fertigung der NbTi-Struktur in Ingotdimension, so dass anschließend die umgeformte NbTi-Struktur in ein Hüllrohr oder in einen Halbzeugblock eingesetzt werden kann. Ansonsten kann durch die querschnittsreduzierende Umformung, die mit einer Längung in Längsrichtung einhergeht, auch eine gewünschte Dimensionierung in Hinblick auf den finalen Supraleiterdraht erreicht werden (ggf. auch mehrstufig über Zwischenbündelungen). Zudem werden die Haftzentren in Längsrichtung gestreckt. Für eine querschnittsreduzierende Umformung kann beispielsweise Extrudieren, Ziehen oder heißisostatisches Pressen angewandt werden. Bevorzugt ist auch eine Variante, bei der nach Fertigung der NbTi-haltigen Struktur diese in ein Hüllrohr, insbesondere ein Cu-Hüllrohr, eingefügt wird. Das Hüllrohr kann im fertigen Supraleiterdraht zur elektrischen Stabilisierung bzw. als Ersatzstrompfad im Quenchfall dienen, und außerdem das mechanische Ziehverhalten verbessern. Ein Hüllrohr kann vor oder nach einer querschnittsreduzierenden Umformung eingesetzt werden.

Besonders bevorzugt ist eine Variante, die vorsieht, dass mehrere NbTi-haltige Strukturen, insbesondere wenigstens 6 NbTi-haltige Strukturen, schichtweise durch selektives Laserschmelzen oder Elektronenstrahlschmelzen gefertigt werden und anschließend in Ausnehmungen eines Halbzeugblocks, insbesondere eines Cu-Halbzeugblocks, eingefügt werden. Der Halbzeugblock kann im fertigen Supraleiterdraht zur elektrischen Stabilisierung bzw. als Ersatzstrompfad im Quenchfall dienen, und außerdem das mechanische Ziehverhalten verbessern. Ein Hüllrohr kann vor oder nach einer querschnittsreduzierenden Umformung eingesetzt werden. Im Hüllblock kann eine Vielzahl (oft mehr als 50) von NbTi-haltigen Strukturen verbaut werden.

Bevorzugt ist auch eine Variante, bei der die eine oder die mehreren zweiten Zonen im Wesentlichen gleichmäßig verteilt im bestrahlten Bereich angeordnet sind. Dadurch kann die Stromtragfähigkeit im Supraleiterdraht optimiert werden; Querströme werden vermieden.

In den Rahmen der vorliegenden Erfindung fällt auch ein Halbzeug für einen Supraleiterdraht, wobei das Halbzeug wenigstens eine NbTi-haltige Struktur aufweist, gefertigt nach einem oben beschriebenen, erfindungsgemäßen Verfahren. Mit dem Halbzeug, in dem auf einfache Weise Haftzentren eingebracht werden können, kann ein Supraleiterdraht gefertigt werden, der eine hohe Stromtragfähigkeit aufweist.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Die nicht maßstabsgetreuen Abbildungen zeigen:
- Fig. 1: einen schematische Ansicht einer Apparatur zur erfindungsgemäßen Fertigung einer NbTi-haltigen Struktur eines Halbzeugs für einen Supraleiterdraht, mit selektivem Laserschmelzen eines Pulvers;
- Fig. 2: eine Aufsicht auf eine zu fertigende Schicht einer NbTi-haltigen Struktur, mit Markierung des Wegs des Strahl-Aufpunkts und erster Zone und zweiten Zonen, gemäß einer erfindungsgemäßen Verfahrensvariante;
- Fig. 3: einen schematischen Querschnitt durch eine gerade in Fertigung befindliche Schicht, gemäß einer erfindungsgemäßen Verfahrensvariante;
- Fig. 4: eine schematische Ansicht einer mit dem erfindungsgemäßen Verfahren gefertigten, NbTi-haltigen Struktur, mit Fertigungsrichtung entlang der Längsrichtung;
- Fig. 5: eine schematische Ansicht einer mit dem erfindungsgemäßen Verfahren gefertigten, weiteren NbTi-haltigen Struktur, mit Fertigungsrichtung senkrecht zur Längsrichtung;
- Fig. 6: eine schematische Illustration des Einbringes einer NbTi-haltigen Struktur in ein Hüllrohr, im Rahmen einer erfindungsgemäßen Verfahrensvariante;
- Fig. 7: eine schematische Illustration des Einbringens von sechs NbTi-haltigen Strukturen in einen Halbzeugblock, im Rahmen einer erfindungsgemäßen Verfahrensvariante;
- Fig. 8: eine schematische Illustration einer Querschnittsreduktion eines Halbzeugs im Rahmen einer erfindungsgemäßen Verfahrensvariante;
- Fig. 9: eine schematische Ansicht einer Apparatur zur erfindungsgemäßen Fertigung einer NbTi-haltigen Struktur eines Halbzeugs für einen Supraleiterdraht, mit selektivem Elektronenstrahlschmelzen eines Pulvers.

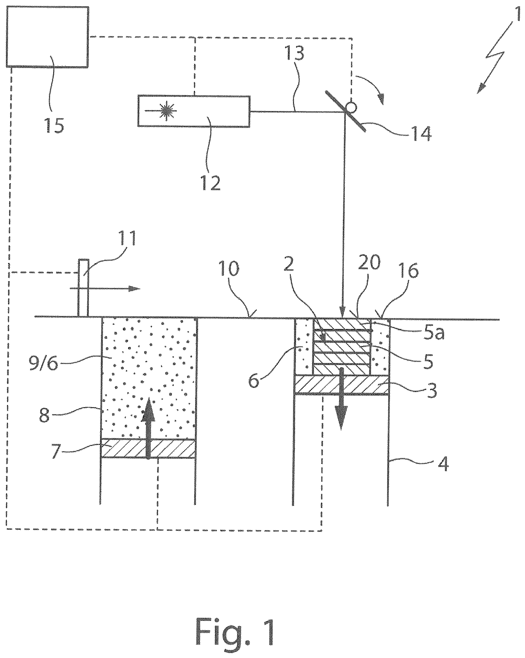

Die Fig. 1 zeigt in einer schematischen, teilweise geschnittenen Ansicht eine Apparatur 1 zur erfindungsgemäßen schichtweisen Fertigung einer NbTi-haltigen Struktur 2 eines Halbzeugs für einen Supraleiterdraht mittels selektivem Laserschmelzen.

Die Apparatur 1 weist eine Bauplattform 3 auf, die in einer Führung 4 vertikal verfahrbar ist. Auf der Bauplattform 3 ist eine teilweise gefertigte NbTi-haltige Struktur 2 angeordnet, von der bereits einige Schichten 5 gefertigt sind.

Weiterhin ist ein Vorratsgefäß 9 mit Pulver (pulverförmigem Material) 6 vorgesehen, wobei ein Pulverboden 7 in einer Führung 8 vertikal verfahrbar ist. Durch Hochfahren des Pulverbodens 7 gelangt eine kleine Menge pulverförmigen Materials 6 über das Niveau eines Apparaturbodens 10, so dass dieses pulverförmige Material 6 über einen horizontal verfahrbaren Schieber 11 zur Bauplattform 3 verbracht werden kann. Im gezeigten Beispiel ist das pulverförmige Material 6 ein Gemisch aus elementarem Titan und elementarem Niob.

Weiterhin ist ein Laser 12 vorgesehen, dessen Laserstrahl 13 der über ein dreh- und/oder verfahrbares Spiegelsystem 14 auf die gesamte Fläche der Bauplattform 3 gerichtet werden kann.

Der Laser 12 (bevorzugt auch dessen Leistung), das Spiegelsystem 14, der Schieber 11, die Bauplattform 3 und der Pulverboden 7 können über eine elektronische Steuereinrichtung 15 automatisch angesteuert werden. In der Steuerung sind CAD-Daten über die zu fertigende NbTi-haltige Struktur 2 enthalten.

Zum Fertigen einer neuen, oben liegenden Schicht 5a der NbTi-haltigen Struktur 2 wird die Bauplattform 3 um eine Schichtdicke (meist ca. 25 µm-100 µm) abgesenkt, der Pulverboden 7 etwas nach oben gefahren und mit dem Schieber 11 pulverförmiges Material 6 über der Bauplattform 3 und der teilweise gefertigten NbTi-haltigen Struktur 2 bis auf das Niveau des Apparaturbodens 10 aufgefüllt und glatt gestrichen. Der Laserstrahl 13 bzw. dessen Aufpunkt überstreicht sodann einen in dieser Schicht 5a vorgesehenen Bereich (bestrahlter Bereich) 20. Dort wird das pulverförmige Material 6 angeschmolzen und verfestigt. Üblicherweise herrscht zumindest um die oben liegende Schicht 5a eine Schutzgasatmosphäre (etwa N2 oder Ar oder Vakuum), um Oxidationsprozesse am heißen bzw. aufgeschmolzenen Material zu vermeiden. Im nicht bestrahlten Bereich 16 bleibt das pulverförmige Material 6 lose.

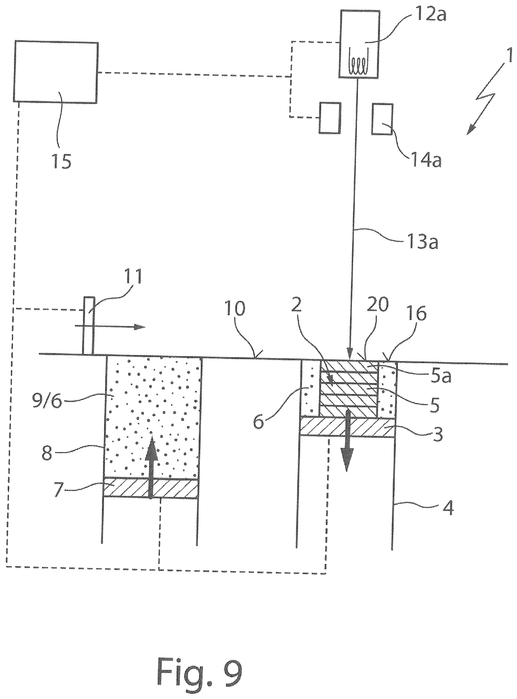

Die **Fig. 9** zeigt eine alternative Apparatur 1 zur schichtweisen Fertigung einer NbTi-haltigen Struktur 2 eines Halbzeugs für einen Supraleiterdraht mittels selektivem Laserschmelzen. Diese Apparatur 1 entspricht weitgehend der Apparatur von Fig. 1, so dass hier nur die wesentlichen Unterscheide erläutert werden.

Mittels einer Elektronenkanone 12a wird ein Elektronenstrahl 13a erzeugt, der mittels eines Linsensystems 14a abgelenkt wird. Der Elektronenstrahl 13a rastert den in der oben liegenden Schicht 5a des Pulvers 6 vorgesehenen Bereich auf der Bauplattform 3 ab. Dazu wird die Elektronenkanone 12a (bevorzugt auch deren Leistung) und das Linsensystem 14a von der Steuereinrichtung 15 entsprechend automatisch angesteuert. Durch die Energie der Elektronen im Elektronenstrahl 13a wird im bestrahlten Bereich 20 das Pulver 6 angeschmolzen und verfestigt. Der Elektronenstrahl 13a propagiert unter Vakuum.

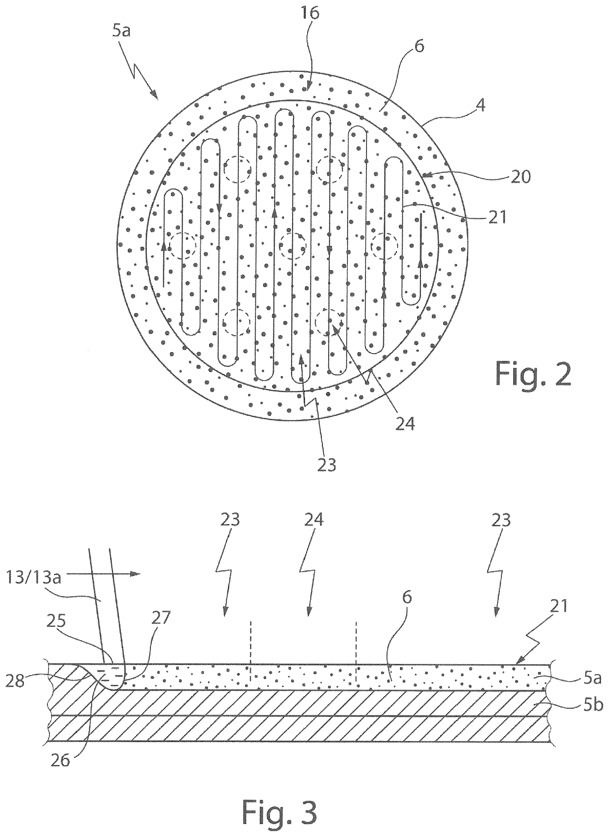

Die **Fig. 2** zeigt eine Aufsicht auf eine oben liegende Schicht 5a pulverförmigen Materials 6 in der Führung 4. Im gezeigten Beispiel ist für eine Materialabscheidung, das heißt eine Verfestigung des pulverförmigen Materials 6, ein kreisscheibenförmiger, bestrahlter Bereich 20 vorgesehen; ein ringförmiger, außen liegender Bereich 16 wird nicht mit dem Laser bzw. der Elektronenkanone bestrahlt.

Der bestrahlte Bereich 20 wird so von einer Bahnkurve 21 für den Aufpunkt des Laserstrahls bzw. Elektronenstrahls abgedeckt/abgefahren, dass der gesamte Bereich 20 nach Einwirkung des Strahls verfestigt wird. Der Strahl folgt bei der Laserschmelzbearbeitung bzw. Elektronenschmelzbearbeitung hier der Bahnkurve 21 (vgl. dazu auch die Pfeilrichtungen).

Erfindungsgemäß ist dabei eine über die Bahnkurve 21 veränderliche Laserschmelzbearbeitung bzw. Elektronenschmelzbearbeitung vorgesehen. Der größte Teil der Bahnkurve 21 unterfällt hier einer ersten Zone 23, und ein kleiner Teil der Bahnkurve 21 unterfällt hier sieben zweiten Zonen 24 (mit gestricheltem Rand markiert). In den gestrichelten zweiten Zonen 24 sollen Haftzentren für Flussschläuche eingerichtet werden. Dazu ist wenigstens ein Parameter der Laserbearbeitung bzw. Elektronenstrahlbearbeitung in der ersten Zone 23 im Vergleich zu den zweiten Zonen 24 verändert. Dadurch erhält das verfestigte Material in der ersten Zone 23 andere Eigenschaften als in den zweiten Zonen 24.

Im illustrierten Beispiel ist es vorgesehen, den Strahl bzw. dessen Aufpunkt innerhalb der ersten Zone 23 mit einer ersten konstanten Vorschubgeschwindigkeit v1 auf der Bahnkurve 21 fortschreiten zu lassen, und in den zweiten Zonen 24 mit einer zweiten konstanten Vorschubgeschwindigkeit v2. Die zweite Vorschubgeschwindigkeit v2 ist dabei deutlich kleiner als die erste Vorschubgeschwindigkeit v1, beispielweise mit v2 ≤ 1/3*v1.

Die **Fig. 3** illustriert in einem schematischen Querschnitt den Fortschritt des Laserstrahls 13 bzw. Elektronenstrahls 13a auf einem Teilabschnitt der Bahnkurve 21 (die in Fig. 3 von links nach rechts verläuft). Der Laserstrahl 13 bzw. Elektronenstrahl 13a erzeugt in einer Umgebung seines Aufpunkts 25 aus dem lokalen pulverförmigem Material 6 in der obersten Schicht 5a ein Schmelzbad 26; ggf. kann dabei auch die darunter liegende (bereits gefertigte, verfestigte) Schicht 5b noch geringfügig angeschmolzen werden. An der Vorderkante 27 des Schmelzbades 26 wird dabei pulverförmiges Material 6 aufgeschmolzen, und an der Hinterkante 28 des Schmelzbades 26 erstarrt das Schmelzbad 26 als verfestigtes Material.

Bei höherer Vorschubgeschwindigkeit (v1 in der ersten Zone 23) ist die Temperatur des Schmelzbades 26 geringer als bei niedriger Vorschubgeschwindigkeit (v2 in der zweiten Zone 24). Dies liegt daran, dass (eine gleichbleibende Strahlleistung voraussetzend) bei niedrigerer Vorschubgeschwindigkeit je Menge aufzuschmelzenden Materials mehr Energie zur Verfügung steht. Bei höherer Schmelzbadtemperatur kommt es zu einem verstärkten Verdampfen von Schmelzbadbestandteilen, in Abhängigkeit vom jeweiligen Bestandteil (insbesondere von dessen Siedepunkt). In einem Gemisch von flüssigem Nb und flüssigem Ti dampft das Ti stärker ab als das Nb, da Ti einen deutlich niedrigeren Siedepunkt bzw. Dampfdruck hat als Nb. Während bei niedriger Temperatur (in der ersten Zone 23) Abdampfprozesse insgesamt sehr gering und daher nicht relevant sind, kann bei einer höherer Temperatur (in der zweiten Zone 24) eine erhebliche Menge Ti abdampfen, während gleichzeitig nur wenig Nb abdampft. Infolgedessen wird im Schmelzbad 26 bei höherer Temperatur (in der zweiten Zone 24) also Ti merklich abgereichert. Hinzu tritt, dass durch die langsamere Vorschubgeschwindigkeit in der zweiten Zone 24 die Verweildauer des Schmelzbades 26 an einem bestimmten Punkt auf der Bahnkurve 21 gegenüber der ersten Zone 23 verlängert ist, was ebenfalls die Abreicherung des leichter flüchtigen Ti begünstigt.

Infolgedessen kommt es zur Ausbildung von unterschiedlichen Phasen in der ersten Zone 23 und in der zweiten Zone 24. Insbesondere führen in der zweiten Zone 24 nicht supraleitende Phasen wie Nb und/oder Nb_{60gew%}Ti_{40gew%}-Phase (=Nb_{44at%}Ti_{56at%}-Phase) zur Ausbildung von künstlichen Haftzentren (artificial pinning centers) in den zweiten Zonen. Dadurch wird die supraleitende Stromtragfähigkeit in der NbTi-haltigen Struktur verbessert.

Man beachte, dass alternativ oder zusätzlich zu einer verlangsamten Vorschubgeschwindigkeit des Laserstrahls bzw. Elektronenstrahls auch beispielsweise die Strahlleistung in den zweiten Zonen erhöht werden kann, oder auch in den zweiten Zonen eine andere Strahlquelle oder gleichzeitig eine zweite Strahlquelle eingesetzt werden kann, oder auch die Fokussierung des Strahls verengt werden kann, was ebenfalls zu einer höheren Schmelzbadtemperatur in den zweiten Zonen 24 führt.

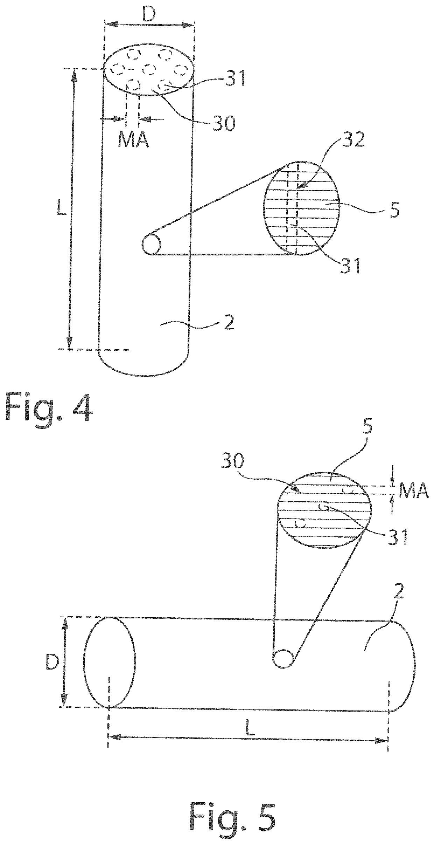

Die **Fig. 4** zeigt eine beispielhafte NbTi-haltige Struktur 2 für ein Halbzeug, die mit einem erfindungsgemäßen Verfahren gefertigt wurde.

Die NbTi-haltige Struktur 2 ist hier im Wesentlichen von kreiszylindrischer Form, mit einer Länge L in Längsrichtung (in Fig. 4 von oben nach unten) und einem Durchmesser D senkrecht zur Längsrichtung. Die NbTi-haltige Struktur 2 weist eine Matrix 30 (entsprechend einer ersten Zone) aus supraleitendem NbTi und hier sieben Einschlüsse 31 (entsprechend zweiten Zonen) auf, in denen eine oder mehrere nicht supraleitende Phasen enthalten sind. Die Einschlüsse 31 wirken als Haftzentren für Flussschläuche im supraleitenden Zustand der NbTi-haltigen Struktur 2. Die Einschlüsse 31 sind hier stabförmig ausgebildet und durchziehen die gesamte Länge L der NbTi-haltigen Struktur 2 in gerader Richtung. Im Querschnitt der NbTi-haltigen Struktur 2 sind die Einschlüsse 31 näherungsweise gleichmäßig verteilt, hier auf einem hexagonalen Gitter.

Die Länge L ist hier ca. 3-mal so groß wie der Durchmesser D. Die Einschlüsse 31 haben hier eine maximale Ausdehnung MA (Durchmesser) quer zur Längsrichtung, der weniger als 1/10 des Durchmessers D der NbTi-haltigen Struktur 2 entspricht. Somit gilt auch MA ≤ 1/30*L.

Die NbTi-haltige Struktur 2 wurde entlang der Längsrichtung gefertigt, so dass die Schichten 5 in Längsrichtung aufeinanderfolgen, siehe vergrößerter Ausschnitt in Fig. 4. Zur Ausbildung der stabförmigen Einschlüsse 31 sind die jeweiligen zweiten Zonen in den aufeinanderfolgenden Schichten 5 überlappend angeordnet; jeder stabförmige Einschluss 31 kann daher als eine zusammenhängende Raumstruktur 32 von zweiten Zonen aufgefasst werden. Die NbTi-haltige Struktur 2 kann mit einer vergleichsweise kleinen Apparatur (vgl. Fig. 1 oder Fig. 9) gefertigt werden.

Die **Fig. 5** zeigt eine weitere, beispielhafte NbTi-haltige Struktur 2 für ein Halbzeug, die mit einem erfindungsgemäßen Verfahren gefertigt wurde.

Die NbTi-haltige Struktur 2 ist hier ebenfalls im Wesentlichen von kreiszylindrischer Form, mit einer Länge L in Längsrichtung (in Fig. 5 von links nach rechts) und einem Durchmesser D senkrecht zur Längsrichtung. Die NbTi-haltige Struktur 2 weist eine Matrix 30 (entsprechend einer ersten Zone) aus supraleitendem NbTi und eine Vielzahl von Einschlüssen 31 (entsprechend zweiten Zonen) auf, in denen eine oder mehrere nicht supraleitende Phasen enthalten sind. Die Einschlüsse 31 wirken als Haftzentren für Flussschläuche im supraleitenden Zustand der NbTi-haltigen Struktur 2. Die Einschlüsse 31 sind hier näherungsweise kugelförmig ausgebildet und sind verteilt in der NbTi-haltigen Struktur 2 angeordnet. Dabei werden Überlappungen verschiedener Einschlüsse 31 in aufeinanderfolgenden Schichten 5 vermieden, vgl. hierzu auch den vergrößerten Ausschnitt in Fig. 5.

Die Länge L ist hier mehr als 3-mal so groß wie der Durchmesser D. Die Einschlüsse 31 haben hier eine maximale Ausdehnung MA (Durchmesser) quer zur Längsrichtung, der weniger als 1/10 des Durchmesser D der NbTi-haltigen Struktur 2 entspricht. Somit gilt auch MA ≤ 1/30*L.

Die NbTi-haltige Struktur 2 wurde quer zur Längsrichtung gefertigt, so dass die Schichten 5 parallel zur Längsrichtung liegen und senkrecht zur Längsrichtung aufeinanderfolgen, siehe vergrößerter Ausschnitt in Fig. 5. Dadurch ist sichergestellt, dass etwaige flächenhafte Fehler bzw. nicht supraleitende Flächen zwischen aufeinanderfolgenden Schichten 5 einen supraleitenden Stromfluss in Längsrichtung nicht behindern.

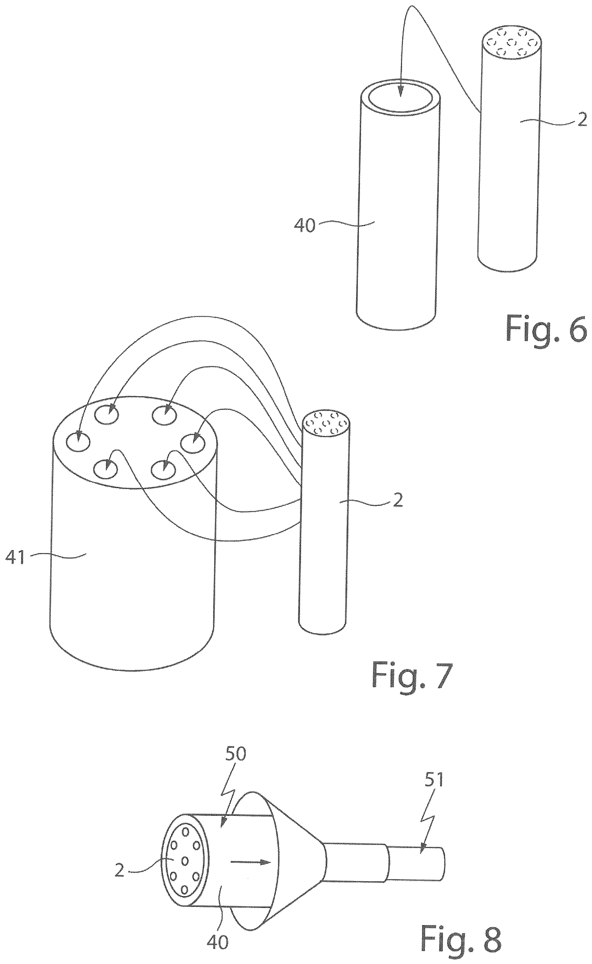

**Fig. 6** illustriert schematisch das Einfügen einer NbTi-haltigen Struktur 2, wie sie beispielsweise in Fig. 4 gezeigt ist, in ein Hüllrohr 40 im Rahmen der Erfindung, um ein Halbzeug herzustellen. Ebenso ist es möglich, mehrere NbTi-haltige Halbzeuge 2 in einen Halbzeugblock 41 einzufügen, wie in Fig. 7 schematisch gezeigt, um ein Halbzeug herzustellen. Es sei aber angemerkt, dass auch eine NbTi-haltige Struktur 2 allein ein Halbzeug eines Supraleiterdrahts darstellen kann.

In **Fig. 8** ist schließlich gezeigt, wie ein Halbzeug 50, hier bestehend aus einem Hüllrohr 40 und einer NbTi-haltigen Struktur 2, extrudiert wird, wodurch ein im Querschnitt reduziertes Halbzeug 51 erhalten wird. Durch Querschnittsreduktion und Bündelung, ggf. auch mehrfach, können Supraleiterdrähte mit vielen einzelnen supraleitenden Filamenten erhalten werden.

### Bezugszeichenliste

- 1: Apparatur
- 2: NbTi-haltige Struktur
- 3: Bauplattform
- 4: Führung
- 5: Schicht
- 5a: oberste Schicht
- 5b: darunterliegende Schicht
- 6: Pulver/pulverförmiges Material
- 7: Pulverboden
- 8: Führung
- 9: Vorratsgefäß
- 10: Apparaturboden
- 11: Schieber
- 12: Laser (Laserquelle)
- 12a: Elektronenkanone
- 13: Laserstrahl
- 13a: Elektronenstrahl
- 14: Spiegelsystem
- 14a: Linsensystem
- 15: elektronische Steuerung
- 16: nicht bestrahlter Bereich
- 20: bestrahlter Bereich
- 21: Bahnkurve
- 23: erste Zone
- 24: zweite Zone
- 25: Aufpunkt
- 26: Schmelzbad
- 27: Vorderkante
- 28: Hinterkante
- 30: Matrix
- 31: Einschluss
- 32: zusammenhängende Raumstruktur
- 40: Hüllrohr
- 41: Halbzeugblock
- 50: Halbzeug
- 51: querschnittsreduziertes Halbzeug
- D: Durchmesser
- L: Länge
- MA: maximale Ausdehnung

## Patentansprüche

1. Verfahren zur Fertigung eines Halbzeugs (50; 51) für einen Supraleiterdraht,
wobei das Halbzeug (50; 51) wenigstens eine NbTi-haltige Struktur (2), insbesondere NbTi-haltige Stabstruktur, umfasst,
**dadurch gekennzeichnet,**
**dass** die NbTi-haltige Struktur (2) schichtweise durch selektives Laserschmelzen oder selektives Elektronenstrahlschmelzen eines Pulvers (6), das Nb und Ti enthält, gefertigt wird,
und **dass** bei der Fertigung zumindest einiger Schichten (5, 5a, 5b) der NbTi-haltigen Struktur (2) über die Fertigung eines für eine Materialabscheidung vorgesehenen, bestrahlten Bereichs (20) einer jeweiligen Schicht (5, 5a, 5b) ein oder mehrere Prozessparameter des selektiven Laserschmelzens oder Elektronenstrahlschmelzens in einer oder mehreren ersten Zonen (23) des bestrahlten Bereichs (20) gegenüber einer oder mehreren zweiten Zonen (24) des bestrahlten Bereichs (20) variiert werden.

2. Verfahren nach Anspruch 1, **dadurch gekennzeichnet, dass** beim selektiven Laserschmelzen oder Elektronenstrahlschmelzen in der oder den zweiten Zonen (24) der Gehalt an Ti gegenüber der oder den ersten Zonen (23) abgereichert wird.

3. Verfahren nach Anspruch 1 oder 2, **dadurch gekennzeichnet, dass** beim selektiven Laserschmelzen oder Elektronenstrahlschmelzen in der oder den zweiten Zonen (24) eine maximale Temperatur eines Schmelzbades (26) gegenüber der oder den ersten Zonen (23) erhöht ist.

4. Verfahren nach einem der vorhergehenden Ansprüche, **dadurch gekennzeichnet, dass** beim selektiven Laserschmelzen oder Elektronenstrahlschmelzen in der oder den zweiten Zonen (24) eine lokale Verweildauer eines Schmelzbades (26) gegenüber der oder den ersten Zonen (23) erhöht ist.

5. Verfahren nach einem der vorhergehenden Ansprüche, **dadurch gekennzeichnet, dass** beim selektiven Laserschmelzen oder Elektronenstrahlschmelzen in der oder den zweiten Zonen (24) eine Strahlleistung gegenüber der oder den ersten Zonen (23) erhöht ist.

6. Verfahren nach einem der vorhergehenden Ansprüche, **dadurch gekennzeichnet, dass** beim selektiven Laserschmelzen oder Elektronenstrahlschmelzen in der oder den zweiten Zonen (24) eine Vorschubgeschwindigkeit (v2) eines Aufpunkts (25) eines Laserstrahls (13) oder Elektronenstrahls (13a) gegenüber einer Vorschubgeschwindigkeit (v1) des Aufpunkts (25) in der oder den ersten Zonen (23) verringert ist.

7. Verfahren nach einem der vorhergehenden Ansprüche, **dadurch gekennzeichnet, dass** beim selektiven Laserschmelzen oder Elektronenstrahlschmelzen in der oder den zweiten Zonen (24) die Fokussierung des Laserstrahls (13) oder Elektronenstrahls (13a) gegenüber der oder den ersten Zonen (23) verändert ist.

8. Verfahren nach einem der vorhergehenden Ansprüche, **dadurch gekennzeichnet, dass** beim selektiven Laserschmelzen oder Elektronenstrahlschmelzen in der oder den ersten Zonen (23) eine erste Laserquelle oder Elektronenkanone eingesetzt wird, und beim selektiven Laserschmelzen oder Elektronenstrahlschmelzen in der oder den zweiten Zonen (24) eine zweite Laserquelle oder Elektronenkanone alternativ oder zusätzlich zur ersten Laserquelle oder Elektronenkanone eingesetzt wird.

9. Verfahren nach einem der Ansprüche 1 bis 8, **dadurch gekennzeichnet, dass** die NbTi-haltige Struktur (29 mit einer Länge L in Längsrichtung und einen maximalen Durchmesser D senkrecht zur Längsrichtung gefertigt wird, mit L≥3*D, bevorzugt L≥4*D, besonders bevorzugt L≥5*D.

10. Verfahren nach Anspruch 9, **dadurch gekennzeichnet, dass** die NbTi-haltige Struktur (2) schichtweise senkrecht zu ihrer Längsrichtung gefertigt wird.

11. Verfahren nach Anspruch 9, **dadurch gekennzeichnet, dass** die NbTi-haltige Struktur (2) schichtweise entlang ihrer Längsrichtung gefertigt wird.

12. Verfahren nach einem der vorhergehenden Ansprüche, **dadurch gekennzeichnet, dass** die eine oder die mehreren zweiten Zonen (24) im bestrahlten Bereich (20) jeweils eine maximale Ausdehnung (MA) zwischen 5 µm und 1000 µm haben.

13. Verfahren nach einem der Ansprüche 1 bis 12, **dadurch gekennzeichnet, dass** in aufeinanderfolgenden Schichten (5, 5a, 5b) zweite Zonen (24) nicht überlappen,
bevorzugt wobei über wenigstens fünf aufeinanderfolgende Schichten (5, 5a, 5b) zweite Zonen (24) nicht überlappen.

14. Verfahren nach einem der Ansprüche 1 bis 12, **dadurch gekennzeichnet, dass** zweite Zonen (24) aufeinanderfolgender Schichten (5, 5a, 5b) zumindest teilweise überlappen, so dass sich in der NbTi-haltigen Struktur (2) eine zusammenhängende Raumstruktur (32) von zweiten Zonen (24) ausbildet.

15. Verfahren nach einem der vorhergehenden Ansprüche, **dadurch gekennzeichnet dass** die NbTi-haltige Struktur (2) einer querschnittsreduzierenden Umformung ausgesetzt wird.

16. Verfahren nach einem der Ansprüche 1 bis 15, **dadurch gekennzeichnet, dass** nach Fertigung der NbTi-haltigen Struktur (2) diese in ein Hüllrohr (40), insbesondere ein Cu-Hüllrohr, eingefügt wird.

17. Verfahren nach einem der Ansprüche 1 bis 15, **dadurch gekennzeichnet, dass** mehrere NbTi-haltige Strukturen (2), insbesondere wenigstens 6 NbTi-haltige Strukturen (2), schichtweise durch selektives Laserschmelzen oder Elektronenstrahlschmelzen gefertigt werden und anschließend in Ausnehmungen eines Halbzeugblocks (41), insbesondere eines Cu-Halbzeugblocks, eingefügt werden.

18. Verfahren nach einem der vorhergehenden Ansprüche, **dadurch gekennzeichnet, dass** die eine oder die mehreren zweiten Zonen (24) im Wesentlichen gleichmäßig verteilt im bestrahlten Bereich (20) angeordnet sind.

19. Halbzeug (50; 51) für einen Supraleiterdraht, wobei das Halbzeug (50; 51) wenigstens eine NbTi-haltige Struktur (2) aufweist, gefertigt nach einem der vorhergehenden Ansprüche.

## Claims

1. A method for producing a semifinished product (50; 51) for a superconductor wire,
wherein the semifinished product (50; 51) comprises at least one NbTi-containing structure (2), in particular an NbTi-containing rod structure,
**characterized in that**
the NbTi-containing structure (2) is produced in layers by selective laser melting or selective electron beam melting of a powder (6) that contains Nb and Ti,
and that, in the production of at least some layers (5, 5a, 5b) of the NbTi-containing structure (2), during the production of an irradiated area (20) intended for material deposition of a respective layer (5, 5a, 5b), one or a plurality of process parameters of the selective laser melting or electron beam melting is/are varied in one or a plurality of first zones (23) of the irradiated area (20) compared to one or a plurality of second zones (24) of the irradiated area (20).

2. The method as claimed in claim 1, **characterized in that** in selective laser melting or electron beam melting in the second zone(s) (24), the content of Ti is degraded compared to the first zone(s) (23).

3. The method as claimed in claim 1 or 2, **characterized in that** in selective laser melting or electron beam melting in the second zone(s) (24), a maximum temperature of a melt bath (26) is increased with respect to the first zone(s) (23).

4. The method as claimed in one of the preceding claims, **characterized in that** in selective laser melting or electron beam melting in the second zone(s) (24), a local residence time of a melt bath (26) is increased with respect to the first zone(s) (23).

5. The method as claimed in one of the preceding claims, **characterized in that** in selective laser melting or electron beam melting in the second zone(s) (24), a beam power is increased with respect to the first zone(s) (23).

6. The method as claimed in one of the preceding claims, **characterized in that** in selective laser melting or electron beam melting in the second zone(s) (24), a feed rate (v2) of a point of incidence (25) of a laser beam (13) or electron beam (13a) is decreased with respect to a feed rate (v1) of the point of incidence (25) in the first zone(s) (23).

7. The method as claimed in one of the preceding claims, **characterized in that** in selective laser melting or electron beam melting in the second zone(s) (24), the focusing of the laser beam (13) or electron beam (13a) is modified with respect to the first zone(s) (23).

8. The method as claimed in one of the preceding claims, **characterized in that** in selective laser melting or electron beam melting in the first zone(s) (23), a first laser source or electron gun is used, and in selective laser melting or electron beam melting in the second zone(s) (24), a second laser source or electron gun is used alternatively or in addition to the first laser source or electron gun.

9. The method as claimed in one of claims 1 through 8, **characterized in that** the NbTi-containing structure (29) is produced with a length L in the longitudinal direction and a maximum diameter D perpendicular to the longitudinal direction, where L ≥ 3*D, preferably L ≥ 4*D, and particularly preferably L ≥ 5*D.

10. The method as claimed in claim 9, **characterized in that** the NbTi-containing structure (2) is produced in layers perpendicularly to its longitudinal direction.

11. The method as claimed in claim 9, **characterized in that** the NbTi-containing structure (2) is produced in layers along its longitudinal direction.

12. The method as claimed in one of the preceding claims, **characterized in that** each of the one or plurality of second zones (24) in the irradiated area (20) has a maximum extension (MA) of between 5 µm and 1000 µm.

13. The method as claimed in one of claims 1 through 12, **characterized in that** second zones (24) do not overlap in successive layers (5, 5a, 5b),
and preferably wherein second zones (24) do not overlap over at least five successive layers (5, 5a, 5b).

14. The method as claimed in one of claims 1 through 12, **characterized in that** second zones (24) at least partially overlap in successive layers (5, 5a, 5b), so that a contiguous spacial structure (32) of second zones (24) forms in the NbTi-containing structure (2).

15. The method as claimed in one of the preceding claims, **characterized in that** the NbTi-containing structure (2) is subjected to reshaping that reduces the cross-section.

16. The method as claimed in one of claims 1 through 15, **characterized in that** after production of the NbTi-containing structure (2), said structure is inserted into a cladding tube (40), in particular a Cu cladding tube.

17. The method as claimed in one of claims 1 through 15, **characterized in that** a plurality of NbTi-containing structures (2), in particular at least 6 NbTi-containing structures (2), are produced in layers by selective laser melting or electron beam melting and then inserted into recesses of a semifinished product block (41), in particular of a Cu semifinished product block.

18. The method as claimed in one of the preceding claims, **characterized in that** the one or plurality of second zones (24) are essentially uniformly distributed in the irradiated area (20).

19. Semifinished product (50; 51) for a superconductor wire, wherein the semifinished product (50; 51) comprises at least one NbTi-containing structure (2) produced as claimed in one of the preceding claims.

## Revendications

1. Procédé de fabrication d'un produit semi-fini (50 ; 51) pour un fil supraconducteur, lequel produit semi-fini (50 ; 51) comprend au moins une structure contenant du NbTi (2), en particulier une structure en barre contenant du NbTi,
**caractérisé en ce**
**que** la structure contenant du NbTi (2) est produite couche par couche par fusion sélective par laser ou par fusion sélective par faisceau d'électrons d'une poudre (6) contenant du Nb et du Ti,
et **que**, lors de la production d'au moins certaines couches (5, 5a, 5b) de la structure contenant du NbTi (2), pendant la production d'une région (20) irradiée, prévue pour un dépôt de matière, d'une couche respective (5, 5a, 5b), on fait varier un ou plusieurs paramètres de processus de la fusion sélective par laser ou par faisceau d'électrons dans une ou plusieurs premières zones (23) de la région irradiée (20) par rapport à une ou plusieurs secondes zones (24) de la région irradiée (20).

2. Procédé selon la revendication 1, **caractérisé en ce que** lors de la fusion sélective par laser ou par faisceau d'électrons dans la ou les secondes zones (24), la teneur en Ti est appauvrie par rapport à la ou aux premières zones (23).

3. Procédé selon la revendication 1 ou 2, **caractérisé en ce que** lors de la fusion sélective par laser ou par faisceau d'électrons dans la ou les secondes zones (24), une température maximale d'un bain de fusion (26) est augmentée par rapport à la ou aux premières zones (23).

4. Procédé selon l'une des revendications précédentes, **caractérisé en ce que** lors de la fusion sélective par laser ou par faisceau d'électrons dans la ou les secondes zones (24), un temps de séjour local d'un bain de fusion (26) est augmenté par rapport à la ou aux premières zones (23).

5. Procédé selon l'une des revendications précédentes, **caractérisé en ce que** lors de la fusion sélective par laser ou par faisceau d'électrons dans la ou les secondes zones (24), une puissance de faisceau est augmentée par rapport à la ou aux premières zones (23).

6. Procédé selon l'une des revendications précédentes, **caractérisé en ce que** lors de la fusion sélective par laser ou par faisceau d'électrons dans la ou les secondes zones (24), une vitesse d'avance (v2) d'un point d'incidence (25) d'un faisceau laser (13) ou d'un faisceau d'électrons (13a) est diminuée par rapport à une vitesse d'avance (v1) du point d'incidence (25) dans la ou les premières zones (23).

7. Procédé selon l'une des revendications précédentes, **caractérisé en ce que** lors de la fusion sélective par laser ou par faisceau d'électrons dans la ou les secondes zones (24), la focalisation du faisceau laser (13) ou du faisceau d'électrons (13a) est modifiée par rapport à la ou aux premières zones (23).

8. Procédé selon l'une des revendications précédentes, **caractérisé en ce qu'**on utilise, pour la fusion sélective par laser ou par faisceau d'électrons dans la ou les premières zones (23), une première source laser ou un premier un canon à électrons et, pour la fusion sélective par laser ou par faisceau d'électrons dans la ou les secondes zones (24), une seconde source laser ou un second canon à électrons à la place ou en plus de la première source laser ou du premier canon à électrons.

9. Procédé selon l'une des revendications 1 à 8, **caractérisé en ce que** la structure contenant du NbTi (2) est produite avec une longueur L dans la direction longitudinale et un diamètre maximal D perpendiculairement à la direction longitudinale, avec L ≥ 3*D, de préférence L ≥ 4*D, en particulier L ≥ 5*D.

10. Procédé selon la revendication 9, **caractérisé en ce que** la structure contenant du NbTi (2) est produite couche par couche perpendiculairement à sa direction longitudinale.

11. Procédé selon la revendication 9, **caractérisé en ce que** la structure contenant du NbTi (2) est produite couche par couche dans sa direction longitudinale.

12. Procédé selon l'une des revendications précédentes, **caractérisé en ce que** la ou les secondes zones (24) de la région irradiée (20) ont chacune une extension maximale (MA) comprise entre 5 µm et 1000 µm.

13. Procédé selon l'une des revendications 1 à 12, **caractérisé en ce que** des secondes zones (24) ne se chevauchent pas dans des couches successives (5, 5a, 5b),
de préférence des secondes zones (24) ne se chevauchant pas sur au moins cinq couches successives (5, 5a, 5b).

14. Procédé selon l'une des revendications 1 à 12, **caractérisé en ce que** des secondes zones (24) de couches successives (5, 5a, 5b) se chevauchent au moins partiellement, de sorte qu'une structure spatiale continue (32) de secondes zones (24) se forme dans la structure contenant du NbTi (2).

15. Procédé selon l'une des revendications précédentes, **caractérisé en ce que** la structure contenant du NbTi (2) est soumise à une mise en forme réduisant la section.

16. Procédé selon l'une des revendications 1 à 15, **caractérisé en ce que**, après la production de la structure contenant du NbTi (2), celle-ci est insérée dans un tube enveloppe (40), en particulier un tube enveloppe en cuivre.

17. Procédé selon l'une des revendications 1 à 15, **caractérisé en ce que** plusieurs structures contenant du NbTi (2), en particulier au moins 6 structures contenant du NbTi (2), sont produites couche par couche par fusion sélective par laser ou par faisceau d'électrons et sont ensuite insérées dans des logements d'un bloc de produit semi-fini (41), en particulier d'un bloc de produit semi-fini en cuivre.

18. Procédé selon l'une des revendications précédentes, **caractérisé en ce que** la ou les secondes zones (24) sont réparties de manière sensiblement uniforme dans la région irradiée (20).

19. Produit semi-fini (50 ; 51) pour un fil supraconducteur, lequel produit semi-fini (50 ; 51) présente au moins une structure contenant du NbTi (2) produite selon l'une des revendications précédentes.
